(19) Europäisches Patentamt / European Patent Office / Office européen des brevets

(11) **EP 1 863 175 A1**

(12) **DEMANDE DE BREVET EUROPEEN**

(43) Date de publication:
**05.12.2007 Bulletin 2007/49**

(51) Int Cl.:
*H03K 17/082* (2006.01)    *H03K 17/14* (2006.01)

(21) Numéro de dépôt: **07109046.8**

(22) Date de dépôt: **28.05.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK YU**

(30) Priorité: **30.05.2006  FR 0651946**

(71) Demandeur: **ST MICROELECTRONICS S.A.**
**92120 Montrouge (FR)**

(72) Inventeur: **MOINDRON, Laurent**
**37390, NOTRE DAME D'OE (FR)**

(74) Mandataire: **de Beaumont, Michel**
**1bis, rue Champollion**
**38000 Grenoble (FR)**

(54) **Protection thermique d'un interrupteur**

(57)    L'invention concerne un procédé et un circuit de détection d'une surchauffe d'un commutateur électronique d'alimentation d'une charge par une tension alternative, dans lesquels une tension représentative de la température au voisinage du commutateur est comparée (41) par rapport à un seuil, le résultat de cette comparaison étant échantillonné (51) à une fréquence correspondant à un multiple pair de la fréquence de la tension alternative d'alimentation, pour fournir un signal (OVT) indicateur d'un dépassement d'un seuil de température.

Fig 8

**Description**

Domaine de l'invention

La présente invention concerne de façon générale les circuits électroniques et, plus particulièrement, la protection d'un interrupteur de commande d'une charge alimentée par une tension alternative contre une éventuelle surchauffe. L'invention s'applique plus particulièrement aux interrupteurs bidirectionnels non commandables en ouverture.

Exposé de l'art antérieur

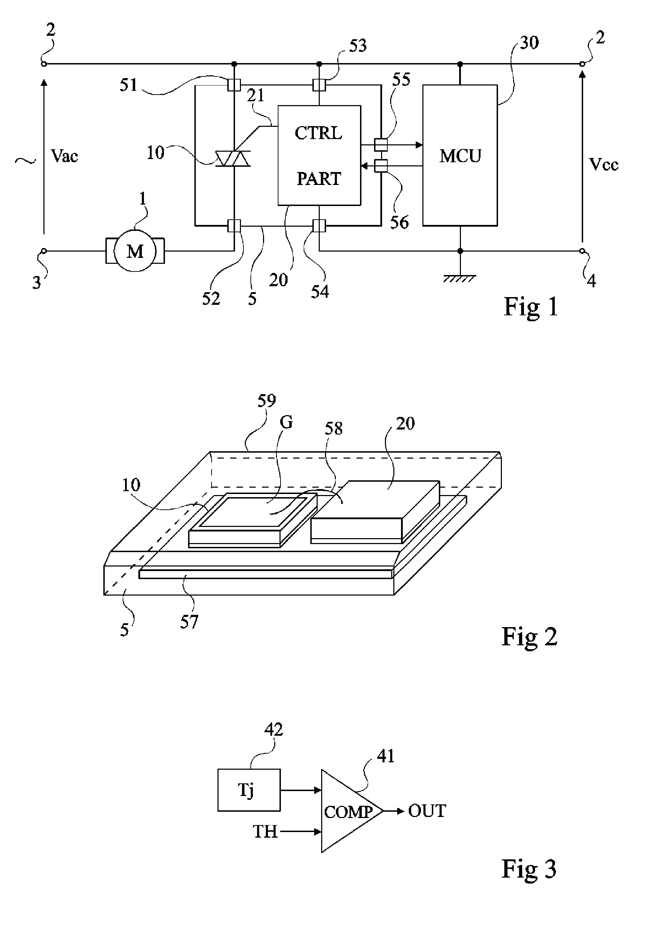

La figure 1 représente, de façon très schématique et sous forme de blocs, un exemple de système d'alimentation d'une charge 1 (M) par une tension alternative Vac, par exemple, la tension secteur du réseau de distribution électrique. La charge 1 est commandée par un interrupteur bidirectionnel 10 (par exemple, un triac) avec lequel elle est connectée en série entre deux bornes 2 et 3 d'application de la tension Vac. L'interrupteur 10 est non commandable à l'ouverture en ce sens qu'il s'ouvre par disparition du courant qui le traverse mais qu'il ne peut pas être ouvert par action sur sa borne de commande. L'interrupteur 10 est associé à un circuit de commande 20 (CTRL PART) en circuit intégré. Le cas échéant, le circuit 20 est commandé par une unité numérique 30 (MCU) qui reçoit alors un ou plusieurs signaux du circuit 20 (notamment un signal indicateur de l'état de l'interrupteur 10) et lui fournit un ou plusieurs signaux de commande. Le circuit de commande 20 et l'unité 30 sont alimentés par une tension continue Vcc appliquée, dans cet exemple, entre la borne 2 et une borne 4 de masse.

L'interrupteur 10 et son circuit de commande 20 sont placés dans un même boîtier 5 dont des bornes de connexion externes sont reliées au reste du montage. Dans cet exemple, deux bornes 51 et 52, reliées à l'intérieur du boîtier 5 aux électrodes de puissance du triac 10, sont connectées respectivement à la borne 2 et à une première borne de la charge 1. Deux bornes 53 et 54 représentent les bornes d'alimentation du circuit de commande 20 et sont donc reliées respectivement aux bornes 2 et 4. Au moins deux bornes 55 et 56 sont reliées à l'unité de commande 30.

La figure 2 est une vue schématique d'un circuit en boîtier 5 comprenant l'interrupteur 10 et son circuit de commande 20. Dans cet exemple, le triac 10 est un composant monolithique rapporté sur un support 57 à côté du circuit intégré 20. La gâchette G du triac est reliée par un conducteur 58 à la borne correspondante 21 (figure 1) du circuit de commande 20. L'ensemble est généralement encapsulé dans une résine 59 pour former le circuit 5.

Dans les applications que vise la présente invention, le circuit de commande 20 comporte un circuit de détection de température destiné à détecter un échauffement de l'interrupteur 10, par exemple, pour détecter une surcharge. Un tel circuit de détection de température compare une information représentative de la température de l'interrupteur (par exemple une température de jonction) par rapport à un seuil pour détecter un éventuel dépassement. Le rôle de cette détection de température est d'inhiber la fermeture (à l'alternance suivante) de l'interrupteur 10 afin d'éviter qu'il soit endommagé.

Le détecteur est soit placé à côté de l'interrupteur 10 comme l'illustre la figure 2 en étant intégré au circuit 20, soit placé directement sur le composant formant l'interrupteur. Dans ce cas, le résultat de la détection est fourni au circuit 20 et/ou au circuit 30.

La figure 3 représente, de façon très schématique, un exemple de détecteur thermique classique. Ce circuit fait généralement partie du circuit 20 (figure 1). Un comparateur 41 (COMP), dont une première entrée reçoit le résultat d'une mesure d'une température de jonction Tj opérée par un détecteur 42 et dont une deuxième entrée reçoit un seuil TH de température, fournit un signal OVT à deux états, indicateur d'un dépassement ou non du seuil TH par la température courante Tj mesurée.

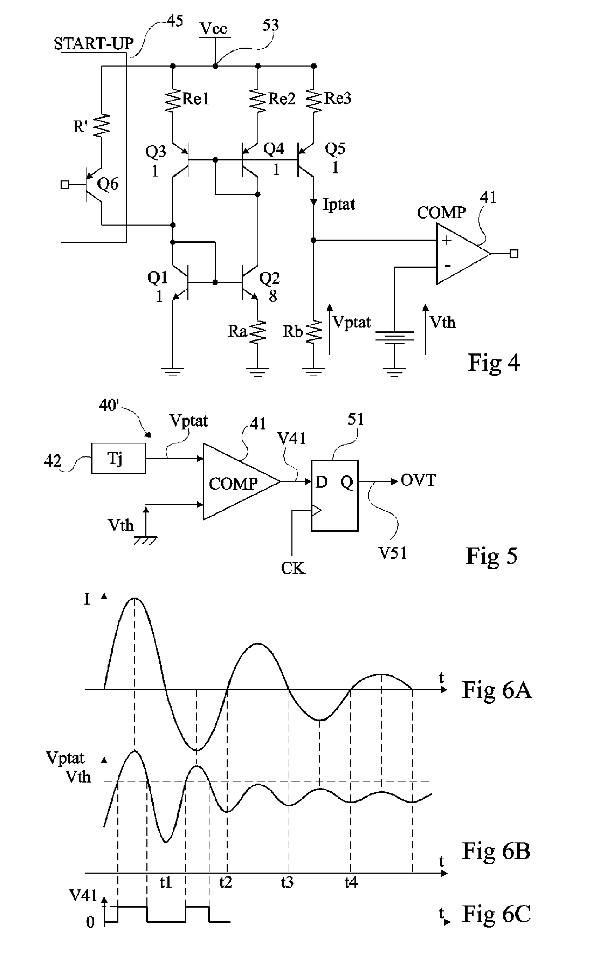

La figure 4 représente un exemple de schéma électrique du détecteur thermique 42 représenté en figure 3. Le comparateur 41 est un amplificateur différentiel dont une entrée (par exemple inverseuse) reçoit une tension Vth de type band-gap, stable en température, et dont l'autre entrée (par exemple non inverseuse) reçoit une tension Vptat proportionnelle à la température du circuit intégré. La tension Vptat est prélevée au point milieu d'une association en série d'un transistor bipolaire de type PNP Q5 et d'une résistance Rb. La résistance Rb connectée à la masse sert de convertisseur courant-tension d'un courant Iptat proportionnel à la température correspondant au courant de collecteur du transistor Q5. L'émetteur du transistor Q5 est relié à la borne 53 d'application de la tension d'alimentation Vcc au moyen d'une résistance Re3. Le transistor Q5 recopie le courant d'une source de courant dite en ΔVbe/R. Cette source est formée de deux branches parallèles entre la borne 53 et la masse. Une première branche comporte, en série, une résistance de polarisation d'émetteur Re1, un transistor bipolaire Q3 de type PNP et un transistor bipolaire Q1 de type NPN. Une deuxième branche comporte, en série, une résistance de polarisation d'émetteur Re2, un transistor bipolaire Q4 de type PNP, un transistor bipolaire Q2 de type NPN et une résistance d'émetteur Ra. Les transistors Q1 et Q4 sont montés en diodes. Le transistor Q4 est monté en miroir sur le transistor Q3 et le transistor Q1 est monté en miroir sur le transistor Q2. En supposant que le transistor Q5 ait la même surface (1) que le transistor Q4, la tension Vptat est fonction de la température T en étant donnée par la relation suivante :

$$Vptat = \frac{Re\,2}{Re\,3} \cdot \frac{Rb}{Ra} \cdot \frac{k \cdot T}{Q} \cdot Ln\left(\frac{a2 \cdot a3}{a1 \cdot a4}\right),$$

où a1, a2, a3 et a4 représentent les surfaces respectives (1, 8, 1 et 1 dans cet exemple) des transistors Q1 à Q4, k désigne la constante de Boltzmann et Q la charge de l'électron.

La seule variable dans la relation ci-dessus est, pour un circuit donné, la température T.

Pour démarrer le circuit, il faut appliquer un courant transitoire à la source en ΔVbe/R. Pour cela, un circuit de démarrage 45 (START-UP), constitué d'une résistance R' en série avec un transistor bipolaire Q6 de type PNP, relie la borne 53 au point milieu (collecteur commun) des transistors Q3 et Q1. La base du transistor Q6 reçoit une impulsion de commande en fermeture pour déclencher une mesure. Cette impulsion est fournie, par exemple, par l'unité 30.

Plus la température augmente, plus la tension Vptat croît. Comme la tension Vth est stable en température, elle fixe un seuil de déclenchement du comparateur. Ce seuil est ajusté par le rapport entre les résistances Rb et Ra. Le comparateur 41 est réalisé, par exemple, au moyen d'un amplificateur opérationnel.

Un inconvénient du détecteur de la figure 4 est que, lors de la mise sous tension initiale de la charge 1, l'interrupteur 10 est susceptible de dépasser la température de déclenchement de façon transitoire. Or, un pic de température de courte durée ne pose généralement pas de problème et ne devrait donc pas être considéré comme une surchauffe. Mais, la sortie du comparateur 41 risque d'inhiber la fermeture de l'interrupteur 10.

Résumé de l'invention

La présente invention vise à pallier tout ou partie des inconvénients des circuits de détection connus d'échauffement d'un interrupteur d'alimentation alternatif.

L'invention vise plus particulièrement à éviter un déclenchement intempestif par des phénomènes de surcharge transitoire.

L'invention vise également une solution compatible avec un fonctionnement sur une charge quelconque (résistive et/ou capacitive et/ou inductive).

Pour atteindre tout ou partie de ces objets ainsi que d'autres, la présente invention prévoit un procédé de détection d'une surchauffe d'un commutateur électronique d'alimentation d'une charge par une tension alternative, dans lequel une tension représentative de la température au voisinage du commutateur est comparée par rapport à un seuil, le résultat de cette comparaison étant échantillonné à une fréquence correspondant à un multiple pair de la fréquence de la tension alternative d'alimentation, pour fournir un signal indicateur d'un dépassement d'un seuil de température.

Selon un mode de mise en oeuvre de la présente invention, la fréquence d'échantillonnage correspond au double de la fréquence de la tension d'alimentation.

Selon un mode de mise en oeuvre de la présente invention, une désactivation dudit signal échantillonné est retardée d'un nombre impair de passage par zéro de la tension alternative d'alimentation.

Selon un mode de mise en oeuvre de la présente invention, ledit nombre impair est 3.

L'invention prévoit également un circuit de détection d'un éventuel échauffement d'un commutateur alternatif, comportant :

un comparateur d'une tension proportionnelle à la température courante par rapport à un seuil ; et
une bascule cadencée à une fréquence correspondant à un multiple pair de la fréquence de la tension alternative.

Selon un mode de réalisation de la présente invention, un compteur d'un nombre impair de passage par zéro de la tension alternative est activé par le signal de sortie de ladite bascule et est cadencée à la même fréquence.

Selon un mode de réalisation de la présente invention, ladite bascule est commandée par un signal de détection du passage par zéro de la tension d'alimentation alternative.

Selon un mode de réalisation de la présente invention, ladite bascule est commandée par un signal de détection du passage par zéro du courant dans l'interrupteur.

Brève description des dessins

Ces objets, caractéristiques et avantages, ainsi que d'autres de la présente invention seront exposés en détail dans la description suivante de modes de mise en oeuvre et de réalisation particuliers faite à titre non-limitatif en relation avec les figures jointes parmi lesquelles :

la figure 1 décrite précédemment représente un exemple d'architecture classique de circuit de commande d'une charge par une tension alternative du type auquel s'applique la présente invention ;

la figure 2 décrite précédemment est une vue schématique d'un circuit intégré formant un interrupteur de commande bidirectionnel ;

la figure 3 décrite précédemment représente, de façon schématique et sous forme de blocs, un exemple classique de circuit de détection de température ;

la figure 4 décrite précédemment représente un exemple classique de schéma électrique du circuit de la figure 3 ;

la figure 5 représente, de façon très schématique et sous forme de blocs, un premier mode de réalisation d'un circuit de détection selon la présente invention ;

les figures 6A, 6B et 6C sont des chronogrammes illustrant le fonctionnement du circuit de la figure 5 ;

les figures 7A, 7B, 7C et 7D sont des chronogrammes illustrant un risque de dysfonctionnement du circuit de la figure 5 sur charge inductive ;

la figure 8 représente un deuxième mode de réalisation d'un circuit de détection selon la présente invention ; et

les figures 9A, 9B, 9C et 9D sont des chronogrammes illustrant le fonctionnement du circuit de la figure 8.

De mêmes éléments ont été désignés par de mêmes références aux différentes figures qui ont été tracées sans respect d'échelle. Par souci de clarté, seuls les éléments utiles à la compréhension de l'invention ont été représentés et seront décrits. En particulier, l'exploitation faite du signal de détection dans le cas d'une commande au moyen d'un microprocesseur n'a pas été détaillée, l'invention étant compatible avec toute exploitation classique effectuée d'un signal de détection de température excédant un seuil.

Description détaillée

La figure 5 représente, de façon très schématique et sous forme de blocs, un premier mode de réalisation d'un circuit 40' de détection de surchauffe selon la présente invention.

Comme précédemment, le circuit 40' utilise un comparateur 41 dont une première entrée reçoit une information Vptat sur une température de jonction Tj (bloc 42) et dont une deuxième entrée reçoit, par exemple, une tension Vth fournie par un générateur de référence de type band-gap. La sortie du comparateur 41 fournit un signal V41 à deux états, indicateur d'un éventuel dépassement. Jusqu'à présent, la structure exposée peut être identique à celle décrite précédemment en relation avec la figure 3.

Selon ce mode de réalisation de l'invention, le signal V41 est échantillonné par une bascule 51 dont une entrée de données D reçoit la sortie du comparateur 41 et dont la sortie Q fournit un signal V51. Le signal V51 constitue dans cet exemple le signal résultat OVT à deux états inhibant la fermeture de l'interrupteur (10, figure 1) en étant fourni au circuit 20 (ou au reste du circuit 20 s'il est intégré avec) et/ou à l'unité 30. L'entrée d'horloge de la bascule 51 reçoit un signal CK dont la fréquence est choisie pour correspondre à un multiple pair (de préférence, le double) de la fréquence de la tension d'alimentation alternative Vac de la charge (1, figure 1).

Les figures 6A, 6B, 6C et 6D illustrent le fonctionnement du détecteur de la figure 5, en supposant une charge purement résistive. La figure 6A représente un exemple d'allure du courant I dans l'interrupteur (10, figure 1) à la mise sous tension. La figure 6B représente l'allure de tension Vptat représentative de la température Tj. La figure 6C représente l'allure du signal V41 de sortie du comparateur 41. On suppose le signal V41 actif (indiquant un dépassement de température) à l'état haut (symbolisé par 1) représentant approximativement le niveau Vcc.

On suppose que sur une première alternance positive de la tension d'alimentation, le courant I (figure 6A) est suffisamment important pour que la tension Vptat excède le seuil Vth (figure 6B) mais qu'il s'agit d'une surcharge temporaire, par exemple, une surcharge transitoire au démarrage (première mise sous tension) de la charge. Il en découle que l'amplitude du courant à l'alternance suivante est inférieure à celle de la première alternance et ainsi de suite sur les alternances suivantes jusqu'à atteindre un régime établi.

Côté mesure de température (figure 6B), l'allure de la tension Vptat suit la décroissance de l'amplitude de la valeur absolue du courant jusqu'à rester en dessous du seuil Vth, par exemple à la troisième demi-période.

Selon ce mode de réalisation de l'invention, le fait d'échantillonner le signal V41 (figure 6C) fourni par le comparateur 41 à des instants t1, t2, t3 et t4 espacés les uns des autres d'une demi-période de la tension d'alimentation permet de ne pas tenir compte des dépassements transitoires de la température acceptable. Bien entendu, si l'échauffement est durable, celui-ci sera présent sur une durée supérieure à la demi-période et sera donc détecté.

L'invention tire profit du fait que l'interrupteur n'est pas commandable en ouverture de sorte que la présence d'un échauffement sur une durée allant jusqu'à la demi-période de la tension d'alimentation alternative ne peut de toute façon pas être évitée, le circuit de commande (20, figure 1) ne pouvant qu'empêcher la fermeture de l'interrupteur lors de l'alternance suivante.

Par conséquent, la mise en oeuvre de l'invention ne nuit pas au fonctionnement du détecteur en cas de réelle surcharge. Elle évite cependant les déclenchements intempestifs.

Le cas échéant, la période d'échantillonnage est supérieure à la demi-période de la tension alternative d'alimentation, pourvu qu'il s'agisse d'un multiple entier de cette demi-période, de façon à éviter d'échantillonner le signal sur les crêtes de courant.

Il ressort de ce qui précède qu'un mode de réalisation préféré de l'invention consiste à choisir les instants d'échantillonnage (fronts actifs du signal CK) approximativement au zéro de tension ou de courant.

Dans le cas d'une charge résistive, une mesure (échantillonnage) au passage par zéro de la tension d'alimentation est généralement plus simple qu'au zéro de courant. Un avantage d'une mesure au zéro de courant est toutefois qu'elle est indépendante du type de charge connectée.

Dans le cas d'une mesure au zéro de tension sur une charge inductive ou capacitive, on peut retarder les instants d'échantillonnage par rapport aux instants de passage par zéro de tension de façon à tenir compte du déphasage entre le courant dans l'interrupteur et la tension d'alimentation. Un tel décalage n'est pas nécessaire en cas de mesure au zéro de courant.

Si le détecteur est posé directement sur l'interrupteur, on préfère une mesure synchronisée sur le zéro de courant dans l'interrupteur, car le temps de propagation de la chaleur peut être considéré comme nul.

Si le détecteur de température est placé à côté de l'interrupteur dans un boîtier comme illustré en figure 2, il existe de toute façon un décalage temporel entre l'évolution de la température de jonction du détecteur 42 et la température vue par l'interrupteur 10, de sorte qu'une mesure par le zéro de tension même sur charge capacitive ou inductive n'est pas dommageable.

En outre, la période de la tension d'alimentation Vac est généralement supérieure à 10 ms (16 à 20 ms pour la tension secteur). Les temps de propagation et incertitudes des détections de passage par zéro du courant ou de la tension sont négligeables devant cette durée.

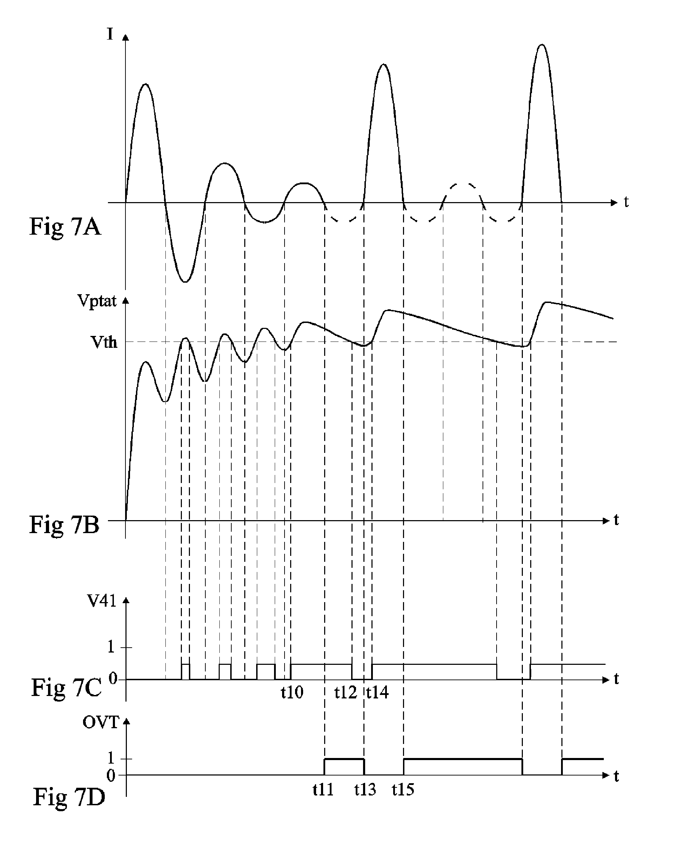

Les figures 7A, 7B, 7C et 7D sont des chronogrammes illustrant, par un exemple d'allures des signaux I, Vptat, V41 et OVT sur une charge inductive, un risque d'instabilité du système avec le détecteur de la figure 5.

On suppose une surcharge devant être détectée, le niveau de température étant supérieur au seuil pendant plus d'une demi-période (à partir d'un instant t10 dans la cinquième alternance). Cette surcharge est prise en compte par la bascule 51 au passage par zéro qui suit (instant t11), ce qui interdit la fermeture de l'interrupteur dans l'alternance débutant à l'instant t11. Cela permet un refroidissement de l'interrupteur. Dans l'exemple, on suppose un refroidissement suffisamment rapide pour que la tension V41 descende en dessous du seuil Vth pendant la sixième alternance (à un instant t12) mais le problème exposé ci-dessous se produit également si plusieurs alternances sont nécessaires. Au passage par zéro (instant t13) qui suit l'instant t12, la bascule 51 désactive le signal OVT et l'interrupteur peut se fermer. Si, comme cela est représenté, le hasard fait que le redémarrage de la charge se produit sur une alternance de même polarité que la dernière alternance de conduction, on assiste sur une charge au moins partiellement inductive à un phénomène de rémanence, donc à une nouvelle surcharge transitoire. Le seuil Vth se retrouve alors immédiatement refranchi (instant t14) avec une amplitude suffisante pour que la durée nécessaire au refroidissement n'évite pas un déclenchement de la sécurité en température (activation du signal OVT à l'instant t15). Si ce phénomène se poursuit, le système devient instable jusqu'à ce que le hasard entraîne un redémarrage sur une alternance de polarité opposée à la dernière alternance de conduction.

Une première solution est de prendre le risque d'une telle instabilité.

Une deuxième solution est de choisir la fréquence d'échantillonnage suffisamment grande devant la fréquence de la tension d'alimentation pour permettre un refroidissement suffisant entre deux redémarrages. Un inconvénient est que c'est au détriment de la rapidité de réaction du système.

Une troisième solution applicable à un circuit commandé par un processeur 30 est d'empêcher, à l'aide de ce processeur, un redémarrage sur une alternance de polarité opposé à la dernière alternance d'alimentation. Cela requiert toutefois de détecter la polarité.

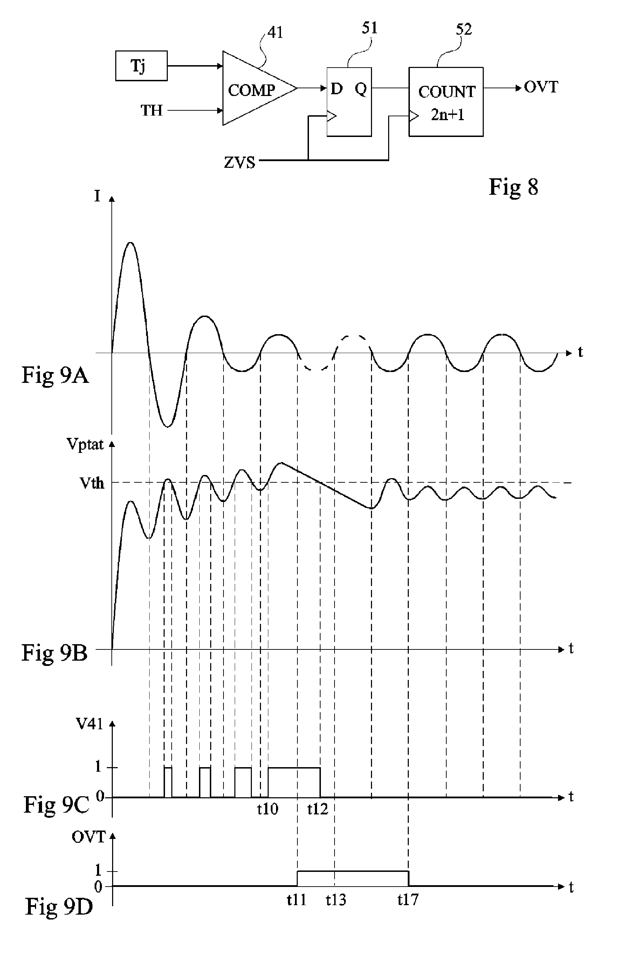

La figure 8 représente un deuxième mode de réalisation d'un circuit de détection de dépassement de température selon la présente invention représentant une quatrième solution préférée au risque d'instabilité sur une charge au moins partiellement inductive. Ce circuit reste basé sur celui de la figure 5 qu'il complète.

La sortie Q de la bascule 51 est envoyée en entrée de déclenchement d'un compteur 52 (COUNT 2n+1, avec n entier positif) dont la sortie fournit le signal résultat OVT. Le compteur est activé par un changement d'état de la sortie Q de sorte que l'activation du signal OVT est immédiate. Le compteur 52 est réinitialisé (ou déborde) après un nombre impair de périodes du signal d'horloge CK de la bascule. Par exemple, le compteur décompte un nombre 2n+1 activé par la bascule 51 et fournit donc une sortie OVT à l'état bas à la fin du décompte. Le choix d'un nombre impair (2n+1) de passages par zéro empêche le redémarrage du commutateur 10 sur une alternance de même polarité que celle où la surcharge a disparu en comptant un nombre pair de périodes secteur.

Les figures 9A, 9B, 9C et 9D sont des chronogrammes représentant un exemple d'allures des signaux I, Vptat, V41 et OVT, à rapprocher de ceux des figures 7A à 7D, pour illustrer le fonctionnement du circuit de la figure 8. Dans cet exemple, le compteur est supposé compter trois passages par zéro (n=1).

Le fonctionnement est identique à celui exposé en relation avec les figures 7A à 7D jusqu'à l'instant t11 d'activation du signal OVT. Mais, à l'instant t13 où, sans compteur, l'échantillonnage du signal V41 permet un redémarrage, ce redémarrage est inhibé tant le compteur n'a pas basculé le signal OVT à l'état 0. A l'instant t17 de fin de comptage, le signal V41 est toujours à l'état bas (la charge n'a pas redémarré depuis l'instant t11). Par conséquent, l'interrupteur 10 est fermé sur alternance de polarité opposée à la dernière alternance de conduction. Le courant I ne présente alors pas de pic (ou un pic très faible par rapport à un redémarrage sur même polarité) de sorte que le signal Vptat, même s'il franchit transitoirement le seuil Vth au moment du redémarrage, ne conduit pas à un nouveau déclenchement de la protection thermique. Bien entendu, si pour une autre raison (température environnementale, temps de refroidissement long, etc.), la tension Vptat est encore supérieure au seuil Vth à l'instant t17, le compteur est réactivé et bloque de nouveau le redémarrage.

La présente invention est susceptible de diverses variantes et modifications qui apparaîtront à l'homme de l'art. En particulier, la réalisation pratique des circuits électroniques de détection illustrés sous forme de blocs fonctionnels est à la portée de l'homme du métier à partir des indications données ci-dessus. De plus, l'obtention d'un signal d'horloge de la bascule et du compteur à partir d'un détecteur du zéro de tension ou de courant fait appel à des circuits classiques, un détecteur du zéro de tension ou de courant étant généralement présent dans le circuit 20 de commande de l'interrupteur. En outre, bien que l'invention ait, pour simplifier l'exposé, été décrite sans tenir compte d'éventuels retards dus aux temps de propagation, leur prise en compte ne pose pas de problème.

**Revendications**

1.  Procédé de détection d'une surchauffe d'un commutateur électronique (10) d'alimentation d'une charge (1) par une tension alternative (Vac), **caractérisé en ce qu'**une tension (Vptat) représentative de la température au voisinage du commutateur est comparée (41) par rapport à un seuil (Vth), le résultat de cette comparaison étant échantillonné (51) à une fréquence (CK) correspondant à un multiple pair de la fréquence de la tension alternative d'alimentation, pour fournir un signal (V51, OVT) indicateur d'un dépassement d'un seuil de température.

2.  Procédé selon la revendication 1, dans lequel la fréquence d'échantillonnage (CK) correspond au double de la fréquence de la tension d'alimentation (Vac).

3.  Procédé selon l'une quelconque des revendications 1 et 2, dans lequel une désactivation dudit signal échantillonné (V51) est retardée (52) d'un nombre impair (2n+1) de passages par zéro de la tension alternative d'alimentation (Vac).

4.  Procédé selon la revendication 3, dans lequel ledit nombre impair est 3.

5.  Circuit de détection d'un éventuel échauffement d'un commutateur alternatif (10), **caractérisé en ce qu'**il comporte :

    un comparateur (41) d'une tension proportionnelle à la température courante par rapport à un seuil ; et
    une bascule (51) cadencée à une fréquence correspondant à un multiple pair de la fréquence de la tension alternative.

6.  Circuit selon la revendication 5, dans lequel un compteur (52) d'un nombre impair de passages par zéro de la tension alternative est activé par le signal de sortie de ladite bascule (51) et est cadencée à la même fréquence.

7.  Circuit selon l'une quelconque des revendications 5 et 6, dans lequel ladite bascule (51) est commandée par un signal de détection du passage par zéro de la tension d'alimentation alternative (Vac).

8.  Circuit selon l'une quelconque des revendications 5 et 6, dans lequel ladite bascule (51) est commandée par un signal de détection du passage par zéro du courant dans l'interrupteur (10).

**Fig 1**

**Fig 2**

**Fig 3**

Fig 4

Fig 5

Fig 6A

Fig 6B

Fig 6C

Fig 7A

Fig 7B

Fig 7C

Fig 7D

Fig 8

Fig 9A

Fig 9B

Fig 9C

Fig 9D

**Office européen des brevets**

**RAPPORT DE RECHERCHE EUROPEENNE**

Numéro de la demande

EP 07 10 9046

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | DE 197 43 253 A1 (SIEMENS AG [DE]) 8 avril 1999 (1999-04-08) * abrégé * * figure 1 * * colonne 1, ligne 12 - ligne 19 * * colonne 4, ligne 1 - colonne 4, ligne 68 * ----- | 1-8 | INV. H03K17/082 H03K17/14 |
| Y | GB 2 315 172 A (SMITHS INDUSTRIES PLC [GB]) 21 janvier 1998 (1998-01-21) * abrégé * * figures 1,2 * * page 1, ligne 16 - ligne 18 * * page 2, ligne 4 - ligne 12 * * page 3, ligne 17 - page 4, ligne 20 * ----- | 1-8 | |
| A | US 5 070 322 A (FUJIHIRA TATSUHIKO [JP]) 3 décembre 1991 (1991-12-03) * abrégé * * figures 2,4,5 * * colonne 7, ligne 38 - colonne 8, ligne 34 * ----- | 1,5 | |
| A | US 2004/179576 A1 (BOWDEN SCOTT J [US] ET AL) 16 septembre 2004 (2004-09-16) * abrégé * * figures 1,10 * * alinéa [0017] - alinéa [0018] * * alinéa [0021] * ----- | 1,5 | DOMAINES TECHNIQUES RECHERCHES (IPC) H03K |
| A | US 5 940 785 A (GEORGIOU CHRISTOS JOHN [US] ET AL) 17 août 1999 (1999-08-17) * abrégé * * figure 2 * * colonne 6, ligne 52 - ligne 58 * * colonne 7, ligne 12 - ligne 50 * ----- | 1,5 | |

Le présent rapport a été établi pour toutes les revendications

| Lieu de la recherche | Date d'achèvement de la recherche | Examinateur |
|---|---|---|
| La Haye | 19 juin 2007 | Oliveira, Joel |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 07 10 9046

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

19-06-2007

| Document brevet cité au rapport de recherche | | Date de publication | Membre(s) de la famille de brevet(s) | | Date de publication |
|---|---|---|---|---|---|
| DE 19743253 | A1 | 08-04-1999 | WO | 9917447 A1 | 08-04-1999 |
| GB 2315172 | A | 21-01-1998 | AU | 3449997 A | 09-02-1998 |
| | | | WO | 9802963 A1 | 22-01-1998 |
| | | | US | 6052268 A | 18-04-2000 |
| US 5070322 | A | 03-12-1991 | AUCUN | | |
| US 2004179576 | A1 | 16-09-2004 | CN | 1531073 A | 22-09-2004 |
| | | | US | 2006029122 A1 | 09-02-2006 |
| US 5940785 | A | 17-08-1999 | US | 6047248 A | 04-04-2000 |

EPO FORM P0460

Pour tout renseignement concernant cette annexe : voir Journal Officiel de l'Office européen des brevets, No.12/82